(19) Europäisches Patentamt
European Patent Office
Office européen des brevets

(11) **EP 2 884 294 A1**

(12) **EUROPÄISCHE PATENTANMELDUNG**

(43) Veröffentlichungstag:
**17.06.2015   Patentblatt 2015/25**

(51) Int Cl.:
**G01R 31/34** *(2006.01)*          **G01R 19/25** *(2006.01)*
**G01R 21/00** *(2006.01)*          **H02P 21/14** *(2006.01)*

(21) Anmeldenummer: **13197203.6**

(22) Anmeldetag: **13.12.2013**

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**
Benannte Erstreckungsstaaten:
**BA ME**

(71) Anmelder: **Siemens Aktiengesellschaft**
**80333 München (DE)**

(72) Erfinder: **Behringer, Klaus**
**91338 Igensdorf (DE)**

(54) **Verfahren zur Ermittlung der Versorgungsspannungen eines Verbrauchers sowie Verbraucher**

(57)   Um in einem mehrphasigen, insbesondere drei-phasigen Versorgungsnetz (2) zuverlässig die Versorgungsspannungen ($U_i$) der einzelnen Stränge (L1, L2, L3) eines Verbrauchers (4) zu ermitteln, ist ein Messmodul (6) vorgesehen, mit dessen Hilfe aus Messspannungen ($U_{i,mess}$) mit Hilfe einer Matrizenoperation die Versorgungsspannungen ($U_i$) ermittelt werden. Über die Matrizenoperation werden insbesondere Potenzialdifferenzen oder Potenzialverschiebungen zwischen dem Messsystem und dem Versorgungsnetz (2) kompensiert, ohne dass hardwaretechnische Maßnahmen, wie beispielsweise ein Spannungsübertrager erforderlich sind.

## FIG 1

EP 2 884 294 A1

**Beschreibung**

Die Erfindung betrifft ein Verfahren zur Ermittlung von Versorgungsspannungen eines Verbrauchers sowie einen Verbraucher.

Bei dem Verbraucher handelt es sich hierbei um einen mehrphasigen Verbraucher, also um einen Verbraucher, der an einem mehrphasigen, insbesondere dreiphasigen Versorgungsnetz angeschlossen ist. Das Versorgungsnetz umfasst dabei mehrere Versorgungsstränge sowie ergänzend ggf. einen zusätzlich Nullleiter-Strang.

Im Rahmen von Monitoring-Systemen beispielsweise zur Überwachung des Zustands des Verbrauchers oder auch zur Überwachung des Energieverbrauchs werden elektrische Kenngrößen des Verbrauchers während des Betriebs ermittelt. Aus diesen Kenngrößen werden dann beispielweise im Rahmen eines Zustands-Monitorings (condition-monitoring) Kennzahlen für Wartung oder Verschleiß abgeleitet. Eine wesentliche Kenngröße ist dabei die Versorgungsspannung für den Verbraucher. Bei einem dreiphasigen Versorgungsnetz weisen die einzelnen Versorgungsspannungen eines jeweiligen Strangs typischerweise eine Phasenbeziehung von 120° auf. Üblicherweise umfasst der Verbraucher mehrere Teilverbraucher, die mit den einzelnen Strängen geeignet verbunden sind. Bei dem Verbraucher handelt es sich beispielsweise um einen Drehstromelektromotor und bei den Teilverbrauchern um einzelne Spulen oder Spulengruppen dieses Elektromotors.

Zur Spannungsmessung derartiger Verbraucher ist es erforderlich, dass die Versorgungsspannungen der einzelnen Stränge ermittelt werden. Hierzu ist üblicherweise jedem Strang ein Spannungsteiler zur Spannungsmessung zugewiesen, wobei die Spannungsteiler zu einem gemeinsamen Messpotenzial als Bezugspunkt verschaltet sind.

In realen Systemen ist jedoch in Abhängigkeit von aktuellen Betriebssituationen die derart gemessene Messspannung eines jeweiligen Strangs nicht zwingend identisch mit der tatsächlich an dem (Teil-)Verbraucher anliegenden Versorgungsspannung. So hängt beispielsweise die jeweilige Versorgungsspannung unter anderem auch davon ab, in welcher Art und Weise der Verbrauche mit dem Versorgungsnetz verschaltet ist, ob beispielsweise über die sogenannte Sternschaltung oder über die sogenannte Dreieckschaltung. Bei ersterer liegt jeweils eine Spannung in Höhe der Spannung des jeweiligen Versorgungsstrangs an, üblicherweise 230 Volt. Im Falle einer Dreieckspannung liegt eine höhere Spannung, typischerweise von etwa 400 Volt an dem Teilverbraucher an. Gleichzeitig würde jedoch jeweils nur eine Messspannung in Höhe von 230 Volt gemessen werden.

Bei einer unsymmetrischen Belastung der verschiedenen Stränge kann dies darüber hinaus auch zu Verschiebungen der Phasenlage führen, wodurch sich ebenfalls Unterschiede ergeben. Schließlich bestehen häufig Potenzialdifferenzen zwischen dem Messpotenzial, also dem Bezugspotenzial für die Messspannung und dem Netzpotenzial, also dem Bezugspotenzial für die einzelnen (Teil-)Verbraucher.

Bei einigen Systemen ist zusätzlich zu den drei Leitersträngen eines dreiphasigen Versorgungsnetzes noch ein zusätzlicher Nullleiter am Verbraucher angeschlossen, welcher in diesem Fall das Netzpotenzial, also das Bezugspotenzial festlegt.

Auch gibt es ländertypische Unterschiede in der Festlegung von Netz-Bezugspotenzialen. So wird beispielsweise in den USA als Bezugspotenzial auch das Potenzial eines der Versorgungsstränge herangezogen.

Zum Ausgleich von Potenzialdifferenzen werden heutzutage sogenannte Spannungsübertrager eingesetzt, welche als Hardware-Bauteile dem Mess-System vorgeschalten sind, um Fehlmessungen aufgrund von Potenzialdifferenzen zu vermeiden. Derartige Spannungsübertrager werden beispielsweise bei externen Messmodulen zur Leistungsmessung eingesetzt. Dies ist jedoch mit einem hohen hardwaretechnischen Aufwand verbunden.

Ausgehend hiervon liegt der Erfindung die Aufgabe zugrunde, ein Verfahren anzugeben, mit dessen Hilfe in einfacher Weise die Versorgungsspannungen eines Verbrauchers in einem mehrphasigen Versorgungsnetz in einfacher Weise korrekt ermittelt werden.

Die Aufgabe wird erfindungsgemäß gelöst durch ein Verfahren mit den Merkmalen des Anspruchs 1 sowie durch einen Verbraucher mit dem Merkmal des Anspruchs 13, welcher zur Durchführung des Verfahrens auch ausgebildet ist.

Das Verfahren dient allgemein zur Ermittlung der Versorgungsspannungen des Verbrauchers mit Hilfe eines Messmodul, insbesondere für ein Zustands- oder Energiemonitoringsystem. Der Verbraucher ist dabei an einem mehrphasigen, insbesondere dreiphasigen Versorgungsnetz angeschlossen, welches mehrere Versorgungsstränge aufweist, nachfolgend kurz als Stränge oder Leiterstränge bezeichnet, an die der Verbraucher angeschlossen ist. Für jeden der Stränge wird eine jeweilige Spannung des Strangs gegen ein gemeinsames Mess- und Bezugspotenzial gemessen. Hierbei wird für jeden Strang eine Messspannung ermittelt. Aus den gemessenen Messspannungen wird durch eine Matrizenbildung mit Hilfe einer Korrekturmatrix die jeweilige Versorgungsspannung ermittelt, die am Verbraucher bzw. an einem jeweiligen Teilverbraucher tatsächlich anliegt.

Der Grundgedanke dieses Konzepts ist darin zu sehen, nicht etwa durch hardwaretechnische Maßnahmen für geeignete Potenzialbezüge zu sorgen, um also beispielsweise Potenzialdifferenzen zwischen dem Messpotenzial und dem Netz-Bezugspotenzial zu vermeiden, sondern derartige Fehler oder Fehlabstimmungen zuzulassen und rein rechnerisch eine Korrektur vorzunehmen. Es wird daher bewusst auf hardwaretechnische Maßnahmen wie beispielsweise die bekannten Spannungsübertrager verzichtet. Mit Hilfe der Korrekturmatrix wird daher insbesondere eine Potenzialdifferenz zwischen dem Messpotenzial und dem Netzpotenzial für die jeweilige Versorgungsspannung des jeweiligen (Teil-)Verbrauchers korrigiert und kompensiert. Dadurch ist insgesamt der hardwaretechnische Aufwand gering gehalten.

Gemäß einer zweckdienlichen Weiterbildung werden für unterschiedliche Betriebssituationen unterschiedliche Korrekturmatrixen herangezogen. Unter unterschiedliche Betriebssituationen sind sowohl Zustände des jeweiligen Verbrauchers als auch Zustände beispielsweise des Versorgungsnetzes oder auch unterschiedliche Zustände aufgrund der Wechselwirkung des Verbrauchers mit dem Versorgungsnetz zu verstehen. Diese unterschiedlichen Korrekturmatrixen sind dabei vorzugsweise innerhalb des Messmoduls hinterlegt und werden jeweils in Abhängigkeit der aktuellen Betriebssituation geeignet ausgewählt.

Vorzugsweise erfolgt dies dabei automatisch, d.h. das Messmodul erkennt automatisch eine aktuelle Betriebssituation und wählt automatisch aus den hinterlegten Korrekturmatrixen die diese Betriebssituation zugeordnete Matrix aus.

Das Verfahren ist dabei vorzugsweise als Algorithmus in einem Halbleiter-Bauteil mit integrierter Schaltung fest integriert. Bei diesem handelt es sich beispielsweise um einen speziell designten ASICs-Baustein.

Insgesamt wird durch die Bereitstellung unterschiedlicher Korrekturmatrixen die Möglichkeit geschaffen, auf unterschiedliche Betriebssituationen flexibel zu reagieren. Das Messmodul weist daher insgesamt eine gewisse Intelligenz auf und entscheidet selber, welche Korrekturmatrix aktuell herangezogen werden muss. Insgesamt lässt sich dadurch auch ein universell einsetzbares Messmodul bereitstellen, welches für die unterschiedlichsten Anwendungsfälle insbesondere auch länderübergreifend eingesetzt werden kann.

Zweckdienlicherweise ist dieses Messmodul mit dem speziell designten Halbleiterbaustein dabei unmittelbar in den jeweiligen Verbraucher als Bestandteil desselben integriert und Teil eines integrierten Zustands- oder Energiemonitoringsystems. Die unterschiedlichen Korrekturmatrizen berücksichtigen dabei insbesondere folgende unterschiedliche Betriebssituationen:

Vorhandensein bzw. Anschluss eines Nullleiters an dem Messmodul, Bestehen einer Potenzialdifferenz zwischen Messpotenzial und Netzpotenzial, Integration des Verbrauchers in das Versorgungsnetz mit einer Sternschaltung sowie Integration des Verbrauchers in das Versorgungsnetz mit einer Dreieckschaltung. Für jeden dieser unterschiedlichen Betriebssituationen ist daher eine eigene, betriebssituations-spezifische Korrekturmatrix verwendet.

Daneben können noch weitere Betriebssituationen durch weitere Korrekturmatrizen berücksichtigt werden, wie beispielsweise eine unsymmetrische Belastung der einzelnen Stränge des Versorgungsnetzes, beispielsweise bei einem Ausfall eines Stranges des Versorgungsnetzes oder auch die Verwendung der Spannung eines Versorgungsstranges als Bezugs- oder Netzpotenzial usw.

In zweckdienlicher Ausgestaltung wird dabei im Rahmen eines Messzyklusses die aktuelle Betriebssituation ermittelt und die zugeordnete Korrekturmatrix ausgewählt. Der Messzyklus wird dabei vorzugsweise während des Betriebs des Verbrauchers wiederkehrend durchgeführt. Dies erfolgt beispielsweise aber nicht zwingend in periodischen Zeitintervallen. Die Zeitintervalle liegen dabei beispielsweise im Bereich von einigen Sekunden bis Minuten. Durch diesen wiederkehrenden Messzyklus ist daher eine permanente Anpassung an den aktuellen Betriebszustand ermöglicht, um ein möglichst genaues Monitoring des Verbrauchers zu gewährleisten. Alternativ hierzu besteht die Möglichkeit, den Messzyklus beispielsweise jeweils bei einer Inbetriebnahme des Verbrauchers durchzuführen, also beispielsweise bei einem Einschalten eines Elektromotors.

Bei leistungsstarken Elektromotoren wird häufig zwischen einem Niederlast- oder Anfahrbetrieb und einem Hochlast- oder Normalbetrieb umgeschalten, wobei im Anfahrbetrieb die einzelnen Spulen des Elektromotors in einer Sternschaltung miteinander verschaltet sind und im Normalbetrieb für eine höhere Leistungsstufe in einer Dreieckschaltung miteinander verschaltet sind. Das Umschalten erfolgt hierbei typischerweise über eine Motorsteuerung und mit Hilfe eines Umschaltsignals. Mit Hilfe dieses Umschaltsignals wird also allgemein der Verbraucher von einem ersten Betriebsmodus in einen zweiten Betriebsmodus versetzt. Dieses Umschaltsignal wird zugleich vom Messmodul erfasst und es wird eine dem neuen Betriebsmodus, also der neuen Betriebssituation entsprechende Korrekturmatrix automatisch ausgewählt.

Gemäß einer bevorzugten Ausführungsvariante wird - sofern ein Anschluss eines Nullleiters an dem Messmodul erkannt wird - eine Nullleiterspannung gemessen und mit Hilfe einer ersten Korrekturmatrix für jeden Strang aus einer Differenz der jeweiligen gemessenen Messspannung und der Nullleiterspannung die jeweilige Versorgungsspannung ermittelt. Hierbei wird in besonders einfacher Weise ausgenutzt, dass über den Nullleiter das Netzpotenzial festgelegt ist und somit durch eine einfache Differenzbildung die tatsächliche Versorgungsspannung ermittelt werden kann.

Zweckdienlicherweise wird bei dem hier beschriebenen Messsystem allgemein automatisch überprüft, ob ein Nullleiter angeschlossen ist. Hierzu wird ein Spannungspegel an einem Nullleitereingang des Messmoduls überprüft und es wird auf einen Anschluss eines Nullleiters erkannt, sofern der an den Nullleitereingang anliegender Spannungspegel eine vorgegebene Bedingung erfüllt. Insbesondere ist diese Bedingung eine Funktion der Messspannungen. Auf einen Nullleiter wird nur dann erkannt, wenn der gemessene Spannungspegel beispielsweise oberhalb eines Wertes liegt in Abhängigkeit der tatsächlichen Messspannungen. Diese Entscheidung in Abhängigkeit der tatsächlichen Messspannung beruht auf der Überlegung, dass bei hohen Spannungen auf den verschiedenen Strängen auch eine gewisse Nullleiterspannung zu erwarten ist. Insbesondere wird dadurch zuverlässig eine Fehlinterpretation vermieden, um nicht fälschlicherweise auf den Anschluss eines Nullleiters zu entscheiden.

Insbesondere für den Fall, dass auf keinen Nullleiter erkannt wurde, wird in zweckdienlicher Ausgestaltung mit Hilfe einer zweiten Korrekturmatrix für jeden Strang die der jeweiligen Messspannung $U_{i,mess}$ zugeordneten Versorgungsspannung $U_i$ aus einer Differenz aus der jeweiligen Messspannung $U_{i,mess}$ und einem Mittelwert Q der gemessenen Spannungen $U_{i,mess}$ gebildet, nämlich $U_i = U_{i,mess} - Q$.

Der Mittelwert Q ist dabei vorzugsweise gebildet aus einem Quotienten aus der Summe der gemessenen Spannungen $U_{i,mess}$ und der Anzahl A der Stränge, $Q = \sum U_{i,mess} / A$. Dies entspricht der Bildung des arithmetischen Mittels.

Der Mittelwert der Messspannungen bildet letztendlich in allgemeiner Weise eine Potenzialverschiebung zwischen dem Messpotenzial und dem Netzpotenzial ab. Die Potenzialdifferenz kann daher als Fehler in der Bezugsspannung des Messpotenzials angesehen werden, welche sich ergibt aus der Mittelung der drei gemessenen Spannungen. Da es sich bei den Spannungen jeweils um zeitabhängige Spannungen mit einem cosinusförmigen Verlauf handelt, wird zudem durch diese Maßnahme auch bei Vorliegen von Potenzialverschiebungen (Phasenverschiebungen) zwischen den einzelnen Strängen eine automatische Korrektur vorgenommen.

Ob eine derartige Potenzialverschiebung zu berücksichtigen ist wird zweckdienlicherweise ebenfalls automatisch ermittelt. Bei einigen Geräten kann eine derartige Potenzialverschiebung durch das spezielle Gerätedesign ausgeschlossen sein. Durch eine entsprechende gerätespezifische Kennung, die dem Messmodul mitgeteilt wird, kann daher durch die Kennung eine Entscheidungsregel im Hinblick auf diese Korrekturmatrix hinterlegt sein, ob die spezielle Korrekturmatrix zu verwenden ist oder nicht. Alternativ oder ergänzend kann eine derartige Entscheidungsregel auch mit Hilfe eines Algorithmus ermittelt werden. Hierzu werden beispielsweise Spannungsteiler des Messmoduls zu einem virtuellen Stern verschaltet, wobei der Sternmittelpunkt das gemeinsame Bezugspotenzial wie bei einer herkömmlichen Sternschaltung bildet. Sind die Messspannungen (betragsmäßig betrachtet) identisch, deutet dies darauf hin, dass eben keine Potenzialverschiebung besteht, andernfalls ist von einer Potenzialverschiebung zwischen den einzelnen Strängen auszugehen.

Bei einer vorteilhaften Ausführungsform wird wenigstens eine der ermittelten Versorgungsspannungen $U_i$ zur Berechnung einer Leistung des mehrphasigen Verbrauchers verwendet.

Bei der Korrekturmatrix handelt es sich vorzugsweise allgemein um eine mx(m+1)-Matrix, wobei m die Anzahl der Versorgungstränge im Versorgungsnetz angibt. Bei einem dreiphasigen Versorgungsnetz ist daher die Korrekturmatrix allgemein als eine 3x4-Matrix ausgebildet. Mit einer derartigen allgemeinen Matrize lassen sich die unterschiedlichen Betriebssituationen im Rahmen des erfindungsgemäßen Matrizenformalismus einfach und treffend abbilden. Die letzte Spalte der Matrize ist im Falle eines fehlenden Nullleiters mit Nullen belegt und im Falle eines Nullleiters mit Werten, insbesondere mit Einsen.

Für die unterschiedlichen Anwendungsfälle werden nachfolgend beispielhaft unterschiedliche Matrizen sowie die Matrizenabbildungen beispielhaft zur Ermittlung der einzelnen Versorgungsspannungen dargestellt. Dabei wird von einem dreiphasigen Versorgungsnetz ausgegangen, an dem der Verbraucher angeschlossen ist. Für Misch-Situationen sind die Matrizen geeignet anzupassen.

Die Messspannungen $U_{1,mess}$, $U_{2,mess}$ und $U_{3,mess}$ sind den jeweiligen Strängen L1, L2 und L3 zugeordnet. Ferner wird am Nullleiter die Spannung $U_{n,mess}$ gemessen. Somit lassen sich die Versorgungsspannungen $U_i = U_1$, $U_2$ und $U_3$ in der Form eines Matrizenformalismus allgemein wie folgt darstellen:

$$\begin{bmatrix} U_1 \\ U_2 \\ U_3 \end{bmatrix} = \bar{M} \cdot \bar{U} = \begin{bmatrix} M_{11} & M_{12} & M_{13} & M_{14} \\ M_{21} & M_{22} & M_{23} & M_{24} \\ M_{31} & M_{32} & M_{33} & M_{34} \end{bmatrix} \cdot \begin{bmatrix} U_{1,mess} \\ U_{2,mess} \\ U_{3,mess} \\ U_{n,mess} \end{bmatrix} \qquad (G1)$$

a) Grundkorrekturmatrix $M_0$ (ohne Nullleiter)

Wird der Anschluss eines Nullleiters nicht erkannt, dann ist die Matrize $\bar{M}$ insbesondere für eine Sternschaltung wie folgt als Grund-Korrekturmatrix $M_0$ darstellbar:

4

$$\overline{M_0} = \begin{bmatrix} 1 & 0 & 0 & 0 \\ 0 & 1 & 0 & 0 \\ 0 & 0 & 1 & 0 \end{bmatrix} \qquad (G2)$$

Vorteilhafterweise können die in der Matrize $\overline{M}$ angegebenen Matrixelemente "1" auch durch einen anderen Skalierungsfaktor ersetzt werden. Mit dieser Grundmatrix $M_0$ werden dabei die Versorgungsspannungen $U_i$ mit den Messspannungen $U_{i,mess}$ gleichgesetzt. Dies ist gültig, falls keine Potenzialdifferenzen und Potenzialverschiebungen vorliegen.

Wichtig ist, dass mit dem Matrizenformalismus ein Fehler berücksichtigt werden kann, der sich insbesondere auf Potenzialdifferenzen beispielsweise zwischen dem Versorgungsnetz, einer Spannungsquelle und dem Messsystem einstellt.

b) erste Korrekturmatrix $M_1$ (mit Nullleiter):

Um zu erkennen, ob ein Nullleiter angeschlossen ist, werden zunächst die gemessenen Spannungen analysiert und der Betragswert der Spannung des Nullleiters mittels nachfolgender Formel verglichen:

$$\left| U_{n,mess} \right| \geq max \left| U_{1,mess}; U_{2,mess}; U_{3,mess} \right| \cdot F$$

$$(G3)$$

Hierbei stellt F einen Skalierungsfaktor dar. Bei den in Formel G1 angegebenen Spannungen handelt es sich um zeitabhängige Sinus oder Cosinus-Funktionen. Die Schwelle kann durch ein Zusammenwirken der gemessenen Spannungen definiert und mittels des Fehlers F skaliert werden. Überschreitet der Betrag von $U_{n,mess}$ diesen skalierten Schwellenwert, so wird der Anschluss eines Nullleiters erkannt.

Die Versorgungsspannung $U_{i,mess}$, beispielsweise $U_1$, i = 1, ergibt sich dann zu:

$$U_1 = U_{1,mess} - U_{n,mess} \qquad (G4)$$

Die Versorgungsspannungen $U_2$ und $U_3$ werden entsprechend gebildet. Damit ergibt sich ausgehend von der Grund-Korrekturmatrix als erste Korrekturmatrix $\overline{M_1}$ für den Fall eines eingeschlossenen Nullleiters

$$\overline{M_1} = \begin{bmatrix} 1 & 0 & 0 & -1 \\ 0 & 1 & 0 & -1 \\ 0 & 0 & 1 & -1 \end{bmatrix}. \qquad (G5)$$

c) zweite Korrekturmatrix $M_2$ (ohne Nullleiter, Potenzialdifferenz)

Für den Fall, dass kein Nullleiteranschluss detektiert wird und ein eventueller Fehler, also eine Potenzialdifferenz oder Potenzialverschiebung korrigiert werden soll, wird zunächst als Mittelwert Q ein Potenzialfehler $U_{Fehler}$ gemäß folgender Formel definiert:

$$U_{Fehler} = \frac{U_{1,mess} + U_{2,mess} + U_{3,mess}}{3}$$

$$(G6)$$

Damit lässt sich $U_1$, die erste Versorgungsspannung, die der gemessenen Spannung $U_{1,mess}$ zugeordnet ist, wie folgt ausdrücken:

$$U_1 = U_{1,mess} - U_{Fehler} = U_{1,mess} - \frac{U_{1,mess} + U_{2,mess} + U_{3,mess}}{3}$$

$$(G7)$$

Hieraus ergibt sich eine zweite Korrekturmatrix $\overline{M_2}$ wie folgt, insbesondere für eine Sternschaltung:

$$\overline{M_2} = \begin{bmatrix} 2/3 & -1/3 & -1/3 & 0 \\ -1/3 & 2/3 & -1/3 & 0 \\ -1/3 & -1/3 & 2/3 & 0 \end{bmatrix}$$

$$(G8)$$

Somit ist ein Spannungsübertrager nicht mehr notwendig.

d) dritte Korrekturmatrix $M_3$ (Grundmatrix Dreieckschaltung)

Für den Fall einer Dreieckschaltung des Verbrauchers lässt sich aus den Messspannungen $U_{i,mess}$ nach der oben angeführten Grundformel G1 die jeweiligen Versorgungsspannungen $U_i$ mit Hilfe folgender dritter Korrekturmatrix $M_3$ ermitteln:

$$\overline{M_3} = \begin{bmatrix} 1 & -1 & 0 & 0 \\ 0 & 1 & -1 & 0 \\ -1 & 0 & 1 & 0 \end{bmatrix} \qquad (G10)$$

Die dritte Korrekturmatrix $M_3$ bildet daher ein System mit Dreieckschaltung ohne Potenzialverschiebung/Potenzialdifferenzen ab. Sie ist daher ebenso wie die Grund-Korrekturmatrix $M_0$ als eine Grundmatrix anzusehen, bei der die Versorgungsspannungen $U_i$ zum einen ($M_0$) für eine Sternschaltung und zum anderen ($M_3$) für eine Dreieckschaltung ermittelt werden. Dies ist insbesondere dann von Bedeutung, wenn bei einem Verbraucher von einer Sternschaltung auf die Dreieckschaltung umgeschaltet wird.

Der Umschaltvorgang bei dem Verbraucher erfolgt dabei üblicherweise mit Hilfe eines Schützes, der mit Hilfe eines Umschaltsignals angesteuert wird. Dieses Umschaltsignal wird bei dem hier beschriebenen Messsystem vom Messmodul erkannt und es wird automatisch zwischen den beiden Grund-Korrekturmatrizen $M_0$ sowie $M_3$ umgeschalten. Insgesamt lässt sich daher durch diesen Matrizenformalismus auch für die Dreiecks-Schaltung aus den Messspannungen $U_i$ die Außenleiterspannung, also die eigentlich Versorgungsspannung der einzelnen (Teil-)Verbraucher ermitteln.

Weitere vorteilhafte Ausbildungen und bevorzugte Weiterbildungen der Erfindungen sind der Figurenbeschreibung und/oder den Unteransprüchen zu entnehmen.

Im Folgenden wird die Erfindung anhand der in den Figuren dargestellten Ausführungsbeispiele näher beschrieben und erläutert.

Es zeigen jeweils in stark vereinfachten Darstellungen:

FIG 1    ein dreiphasiges Versorgungsnetz mit einem angeschlossenen Verbraucher und mit einem Messmodul, sowie

FIG 2    ein Flussdiagramm zur Erläuterung des Verfahrens.

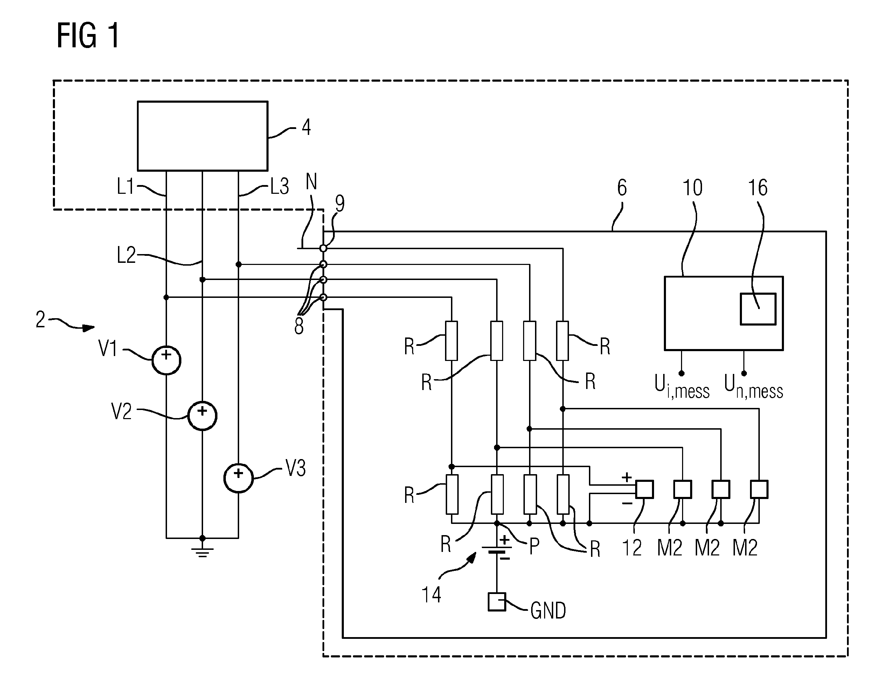

In FIG 1 ist ein dreiphasiges Strom- oder Versorgungsnetz dargestellt, an dem ein Verbraucher 4 angeschlossen ist. Bei dem Versorgungsnetz 2 handelt es sich um ein dreiphasiges Versorgungsnetz mit drei Versorgungssträngen L1, L2, L3. Jedem Versorgungsstrang L1, L2, L3 ist jeweils eine Spannungsquelle V1, V2, V3 zugeordnet.

Weiterhin zeigt FIG 1 ein Messmodul 6, welches vorzugsweise im Verbraucher 4 integriert ist, wie dies in der FIG 1 schematisiert durch die gestrichelte Linie dargestellt ist. Das Messmodul 6 weist insgesamt drei Leitereingänge 8 sowie einen Nullleitereingang 9 auf, über die das Messmodul jeweils mit einem der Stränge L1, L2, L3 des Versorgungsnetzes 2 und gegebenenfalls mit einem Nullleiter N verbunden werden kann. In FIG 1 ist das Versorgungsnetz 2 ohne Nullleiter N dargestellt, dieser ist zu Illustrationszwecken lediglich durch eine gestrichelte Linie angedeutet.

Bei dem Verbraucher 4 handelt es sich vorzugsweise um einen drehstombetriebenen Elektromotor oder auch einen sonstigen drehstrombetriebenen Verbraucher.

Das Messmodul 6 ist Teil eines Monitoring-Systems zur Überwachung und Kontrolle des Verbrauchers 4 insbesondere im Hinblick auf dessen Zustand, wie beispielsweise Verschleiß etc. im Rahmen eines Condition-Monitorings und vorzugsweise aber auch im Hinblick auf ein Energie-Monitoring, um Aussagen über Energie, Verbrauch und Leistung des Verbrauchers 4 zu erhalten. Hierzu wird mit Hilfe des Messmoduls 6 eine jeweilige Versorgungsspannung $U1, U2, U3$ in einem jeweiligen Versorgungsstrang L1, L2, L3 bestimmt. In einem ersten Schritt wird hierzu beispielsweise mit der in Figuren dargestellten Messschaltung zu jedem einzelnen Versorgungsstrang L1, L2, L3 eine Messspannung $U_{i,mess}$ ermittelt, i = 1,2,3 und an eine Auswerteeinheit 10 des Messmoduls 6 übermittelt. In dieser wird durch die zuvor beschriebenen Matrizenoperationen dann aus diesen Messspannungen $U_{i,mess}$ für jeden Strang L1, L2, L3 eine Versorgungsspanung $U_i$ errechnet.

Zur Ermittlung der Messspannungen $U_{i,mess}$ ist jedem Strang L1, L2, L3 ein Spannungsteiler zugewiesen, gebildet aus zwei Widerständen R, zwischen denen ein Spannungsabgriff eines jeweiligen Spannungsmessers 12 erfolgt. Alle Spannungsmesser 12 sind mit einem gemeinsamen als Messpotenzial P ausgebildeten Potential verschaltet.

Im Ausführungsbeispiel weist das Messmodul 6 eine eigene Spannungsquelle 14 auf, die das Messpotenzial P festlegt und selbst wiederum gegen Massepotenzial GND geerdet ist. Die von den Spannungsmessern 12 gemessenen Messspannungen $U_{i,mess}$ werden in hier nicht näher dargestellter Weise an die Auswerteeinheit 10 übermittelt. Ebenso wie die Anschlüsse der Leiterstränge L1, L2, L3 wird auch der Spannungspegel am Nulleiteranschluss N abgegriffen und der von dem Spannungsmesser 12 gemessene Wert wird als Nullleiterspannung $U_{n,mess}$ an die Auswerteeinheit 10 übermittelt.

Über die Spannungsteiler werden die abgegriffenen Spannungen der Leiterstränge L1, L2, L3 im Bereich von beispielsweise 100 bis etwa 700 Volt auf den Spannungspegel des Messsystems zurückgeführt. Durch die Verschaltung der einzelnen Spannungsteiler auf das gemeinsame Messpotenzial P werden diese quasi zu einem virtuellen Stern verschaltet. Im Ausführungsbeispiel ist dieses Spannungspotential P aufgrund der Spannungsquelle 14 um ein festes Potenzial gegenüber dem Massepotenzial GND verschoben. Mit dieser Messanordnung werden die üblicherweise sternförmige Anordnung und der sternförmige Anschluss des Verbrauchers 4 nachgebildet.

Die gemessenen Spannungen $U_{i,mess}$ stimmen jedoch nur im streng symmetrischen Betrieb mit den tatsächlichen Versorgungsspannungen $U_i$ überein und insbesondere auch nur unter der Bedingung, dass keine Potenzialdifferenz zwischen dem Messpotenzial P und einem Referenzpotenzial des Verbrauchers 4 (Netzpotenzial) besteht. Häufig liegen jedoch solche Potenzialdifferenzen vor und üblicherweise ist der Betrieb nicht streng symmetrisch, d.h. die Amplituden der Spannungen in den einzelnen Versorgungssträngen L1, L2, L3 sind nicht identisch und/oder die Phasenbeziehung zwischen den einzelnen Leitersträngen L1, L2, L3 liegen nicht exakt 120° auseinander.

Durch das Messmodul 6 werden derartige Fehler wie zuvor beschrieben ausschließlich durch die beschriebenen Matrizenoperationen kompensiert. Die erhaltenen Werte für die Versorgungsspannungen $U_i$ werden dann für das Monitoring-System herangezogen. Das Verfahren zur Ausübung der Matrizenoperation ist in der Auswerteeinheit 10 implementiert. Diese ist insbesondere als eine integrierte Schaltung ausgebildet oder weist eine solche auf. Die integrierte Schaltung ist insbesondere ein Mikrochip oder eine anwendungsspezifische integrierte Schaltung (Application Specific Integrated Circuit, ASIC). Der Algorithmus ist daher fest in der Halbleiterstruktur der integrierten Schaltung implementiert. Diese integrierte Schaltung wird vorliegend auch als "Power-ASIC" bezeichnet, um anzugeben, dass hier die Schaltung zur Leistungsmessung für ein Monitoring-System ausgebildet ist. Innerhalb dieses integrierten Schaltkreises ist vorzugsweise auch ein Speicher 16 implementiert, in dem unterschiedliche Matrizen M hinterlegt sind.

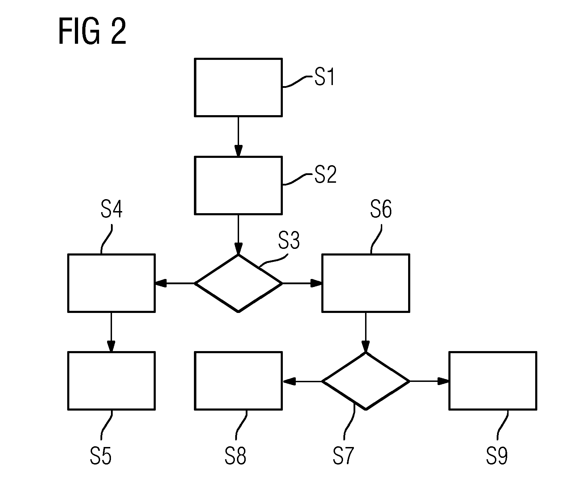

Zur Bestimmung und Ermittlung der Versorgungsspannungen $U_i$ wird regelmäßig ein Messzyklus durchgeführt, wie er nachfolgend anhand der FIG 2 und 3 erläutert wird. Der Messzyklus startet im ersten Schritt S1. Dieser Start wird beispielsweise durch Anschalten des Verbrauchers 4 oder auch in wiederkehrenden Zeitabständen während des Betriebs des Verbrauchers 4 veranlasst. Im darauffolgenden Schritt S2 erfolgt zunächst eine Spannungsmessung des Nullleiters N. Im Schritt S3 wird dann überprüft, ob der von dem entsprechenden Messmodul 12 ermittelte Spannungswert des Nullleitereingangs 9 größer einer vorgegebenen Schwelle ist. Falls ja, wird im Schritt S4 entschieden, dass ein Nullleiter N vorhanden ist. Im anschließenden Schritt S5 erfolgt dann die Auswahl einer zugeordneten Korrekturmatrix, beispielsweise die erste Korrekturmatrix $M_1$. Im Folgenden wird dann die Ermittlung des Wertes für die Versorgungsspannung $U_i$ für einen jeden Strang für das Monitoring-System kontinuierlich oder in durch das Monitoring-System vorgegebenen Zeitintervallen mit Hilfe der ausgewählten Korrekturmatrix $M_n$ ermittelt.

Wird bei der Schwellwertabfrage im Schritt S3 festgestellt, dass der Betrag der gemessenen Nulleiterspannung $U_{n,mess}$ den Schwellwert unterschreitet bzw. nicht erreicht, so wird dies im Schritt S6 dahingehend ausgewertet, dass kein Nullleiter N vorhanden ist.

In einem weiteren Entscheidungsschritt S7 wird dann überprüft, ob eine Potenzialverschiebung kompensiert werden soll. Diese Entscheidung ist beispielsweise durch eine gerätespezifische Konfiguration voreingestellt, wird also je nach Implementierung geräteabhängig entschieden. Sofern keine Potenzialverschiebung berücksichtigt werden soll, erfolgt im Schritt S8 eine konventionelle Berechnung beispielsweise über die Korrekturmatrix $M_0$ im Falle einer Stern-schaltung oder $M_2$ im Falle einer Dreieckschaltung. Die Entscheidungsregel, ob eine Potenzialverschiebung kompensiert werden soll, kann alternativ auch über einen Algorithmus entschieden werden. Hierzu werden beispielsweise die gemessenen einzelnen Messspannungen $U_{i,mess}$ ausgewertet und überprüft, ob diese hinsichtlich ihrer Beträge identisch sind. Ist dies nicht der Fall, wird dies als Indiz dafür gewertet, dass eine Potenzialverschiebung vorliegt.

Soll eine Potenzialverschiebung kompensiert werden, so wird im Schritt S9 unter Zuhilfenahme einer entsprechend ausgewählten Korrekturmatrix, beispielsweise die zweite Korrekturmatrix $M_2$ aus den gemessenen Spannungs-werten $U_{i,mess}$ die Versorgungsspannungen $U_i$ ermittelt.

## Patentansprüche

1.  Verfahren zur Ermittlung der Versorgungsspannungen ($U_i$) eines Verbrauchers (4) mit Hilfe eines Messmoduls (6), insbesondere für ein Zustands- oder Energiemonitoring -System, wobei der Verbraucher (4) an einem mehrphasigen Versorgungsnetz (2) mit mehreren Strängen (Li) angeschlossen ist, wobei für jeden der Stränge (Li) eine Spannung gegen ein gemeinsames Messpotenzial gemessen wird und hierbei für jeden Strang eine Messspannung ($U_{i,mess}$) ermittelt wird, wobei aus den Messpannungen ($U_{i,mess}$) durch eine Matrizenabbildung mit Hilfe einer Korrekturmatrix ($M_n$) die Versorgungsspannungen ($U_i$) ermittelt werden.

2.  Verfahren nach Anspruch 1, bei dem für unterschiedliche Betriebssituationen unterschiedliche Korrekturmatrizen ($M_n$) herangezogen werden.

3.  Verfahren nach Anspruch 2, bei dem unterschiedliche Betriebssituationen automatisch erkannt werden und die der jeweiligen Betriebssituation zugeordnete Korrekturmatrix ($M_n$) automatisch für die Matrizenabbildung herangezogen wird.

4.  Verfahren nach Anspruch 3, bei dem im Rahmen eines Messzyklusses die Betriebssituation ermittelt und die zu-geordnete Korrekturmatrix ($M_n$) ausgewählt und für die Matrizenbildung herangezogen wird, wobei der Messzyklus während des Betriebs des Verbrauchers wiederkehrend vorzugsweise in einem Intervall von einigen Sekunden durchgeführt wird.

5.  Verfahren nach einem der Ansprüche 2 bis 4, bei dem in Abhängigkeit eines Umschaltsignals, das den Verbraucher (4) von einem ersten Betriebsmodus in einen zweiten Betriebsmodus versetzt, eine dem jeweiligen Betriebsmodus zugeordnete Korrekturmatrix ($M_n$) ausgewählt wird.

6.  Verfahren nach Anspruch 5, bei dem der Verbraucher (4)in Abhängigkeit des Umschaltsignals wahlweise in einer Sternschaltung oder in einer Dreieckschaltung betrieben wird und jeweils eine der Schaltung zugeordnete Korrek-turmatrix ($M_n$) ausgewählt wird.

7.  Verfahren nach einem der vorhergehenden Ansprüche, bei dem eine Nullleiterspannung ($U_{n,mess}$) gemessen wird, sofern ein Anschluss eines Nullleiters (N) erkannt wird, und mit Hilfe einer ersten Korrekturmatrix ($M_1$) für jeden Strang (Li) aus einer Differenz der jeweiligen Messspannung ($U_{i,mess}$) und der Nullleiterspannung ($U_{n,mess}$) die jeweilige Versorgungsspannung ($U_i$) ermittelt wird, nämlich $Ui = U_{i,mess} - U_{n,mess}$.

8.  Verfahren nach einem der vorhergehenden Ansprüche, bei dem auf einen Anschluss eines Nullleiters (N) automatisch in Abhängigkeit des Werts der an einem Nulleitereingang (9) des Messmoduls (6) anliegenden Spannung erkannt wird.

9.  Verfahren nach einem der vorhergehenden Ansprüche, bei dem mit Hilfe einer zweiten Korrekturmatrix ($M_2$) für jeden Strang (Li) die der jeweiligen Messspannung ($U_{i,mess}$) zugeordnete Versorgungsspannung ($U_i$) aus einer Differenz aus der jeweiligen gemessenen Spannung ($U_{i,mess}$) und einem Mittelwert (Q) der gemessenen Spannungen ($U_{i,mess}$) gebildet wird, nämlich $U_i = Ui,mess - Q$.

10. Verfahren nach Anspruch 9, wobei der Mittelwert (Q) aus einem Quotienten aus der Summe der Messspannungen ($U_{i,mess}$) durch eine Anzahl A der Messspannungen ($U_{i,mess}$) gebildet ist, also $Q = \sum U_{i,mess}/ A$.

**11.** Verfahren nach einem der vorhergehenden Ansprüche, wobei zumindest eine der ermittelten Versorgungsspannungen ($U_i$) zur Berechnung einer Leistung des Verbrauchers (4) verwendet wird.

**12.** Verfahren nach einem der vorhergehenden Ansprüche, wobei die Korrekturmatrix ($M_n$) bei einem dreiphasigen Versorgungsnetz als eine 3X4-Matrix ausgebildet ist.

**13.** Verbraucher (4), insbesondere Elektromotor mit einem integrierten Messmodul (6) zur Durchführung des Verfahrens nach einem der vorhergehenden Ansprüche.

FIG 1

FIG 2

Europäisches
Patentamt

European
Patent Office

Office européen
des brevets

**EUROPÄISCHER RECHERCHENBERICHT**

Nummer der Anmeldung

EP 13 19 7203

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (IPC) |
|---|---|---|---|
| X | AU 2003 204 811 A1 (MITSUBISHI ELECTRIC CORP) 5. August 2004 (2004-08-05) * Seite 5, Zeile 20 - Seite 18, Zeile 32 * ----- | 1-13 | INV. G01R31/34 G01R19/25 G01R21/00 H02P21/14 |
| A | FANG ZHENG PENG ET AL: "Generalized Instantaneous Reactive Power Theory for Three-Phase Power Systems", IEEE TRANSACTIONS ON INSTRUMENTATION AND MEASUREMENT, IEEE SERVICE CENTER, PISCATAWAY, NJ, US, Bd. 45, Nr. 1, 1. Februar 1996 (1996-02-01), XP011023999, ISSN: 0018-9456 * das ganze Dokument * ----- | 1-13 | |
| A | US 2007/005194 A1 (CHANG LIUCHEN [CA] ET AL) 4. Januar 2007 (2007-01-04) * Absatz [0032] - Absatz [0049] * ----- | 1-13 | |
| A | US 2012/150468 A1 (SAHINOGLU ZAFER [US] ET AL) 14. Juni 2012 (2012-06-14) * Absatz [0014] - Absatz [0048] * ----- | 1-13 | RECHERCHIERTE SACHGEBIETE (IPC) G01R H02P |

Der vorliegende Recherchenbericht wurde für alle Patentansprüche erstellt

| Recherchenort | Abschlußdatum der Recherche | Prüfer |
|---|---|---|
| München | 6. Juni 2014 | Meggyesi, Zoltán |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus anderen Gründen angeführtes Dokument

................................................................
& : Mitglied der gleichen Patentfamilie, übereinstimmendes Dokument

EPO FORM 1503 03.82 (P04C03)

**ANHANG ZUM EUROPÄISCHEN RECHERCHENBERICHT
ÜBER DIE EUROPÄISCHE PATENTANMELDUNG NR.**

EP 13 19 7203

In diesem Anhang sind die Mitglieder der Patentfamilien der im obengenannten europäischen Recherchenbericht angeführten Patentdokumente angegeben.
Die Angaben über die Familienmitglieder entsprechen dem Stand der Datei des Europäischen Patentamts am
Diese Angaben dienen nur zur Unterrichtung und erfolgen ohne Gewähr.

06-06-2014

| Im Recherchenbericht angeführtes Patentdokument | Datum der Veröffentlichung | Mitglied(er) der Patentfamilie | Datum der Veröffentlichung |
|---|---|---|---|
| AU 2003204811 A1 | 05-08-2004 | AU 2003204811 A1<br>CN 1517715 A<br>JP 4310113 B2<br>JP 2004219288 A | 05-08-2004<br>04-08-2004<br>05-08-2009<br>05-08-2004 |
| US 2007005194 A1 | 04-01-2007 | KEINE | |
| US 2012150468 A1 | 14-06-2012 | JP 2012130238 A<br>US 2012150468 A1 | 05-07-2012<br>14-06-2012 |

EPO FORM P0461

Für nähere Einzelheiten zu diesem Anhang : siehe Amtsblatt des Europäischen Patentamts, Nr.12/82